# EUROPÄISCHE PATENTSCHRIFT

(11) **EP 2 578 724 B1**
(45) Veröffentlichungstag und Bekanntmachung des Hinweises auf die Patenterteilung: **29.04.2015**
(21) Anmeldenummer: 12186827.7
(22) Anmeldetag: 01.10.2012
(51) Int. Cl.: C23C 16/24, C01B 33/035

(54) **Vorrichtung und Verfahren zur Abscheidung von polykristallinem Silicium**
Apparatus and process for deposition of polycrystalline silicon
Dispositif et procédé destinés à la séparation du silicium polycristallin

(30) Priorität: 07.10.2011 DE 102011084137
(43) Veröffentlichungstag der Anmeldung: 10.04.2013
(73) Patentinhaber: Wacker Chemie AG, 81737 München (DE)
(72) Erfinder: Sofin, Mikhail, Dr., 84489 Burghausen (DE)
(74) Vertreter: Killinger, Andreas

(56) Entgegenhaltungen:
- WO-A1-2010/098319
- CN-A- 102 134 745
- DE-B3-102009 003 368
- JP-A- 2003 128 492
- US-A- 4 681 652
- US-A1- 2009 136 408

## Beschreibung

Hochreines polykristallines Silicium (Polysilicium) dient als Ausgangsmaterial zur Herstellung von einkristallinem Silicium für Halbleiter nach dem Czochralski(CZ)- oder Zonenschmelz(FZ)-Verfahren, sowie zur Herstellung von ein- oder multikristallinem Silicium nach verschiedenen Zieh- und GießVerfahren zur Produktion von Solarzellen für die Photovoltaik.

Polysilicium wird üblicherweise mittels des Siemens-Verfahrens hergestellt. Dabei wird ein Reaktionsgas umfassend eine oder mehrere Silicium enthaltende Komponenten und gegebenenfalls Wasserstoff in einen Reaktor umfassend durch direkten Stromdurchgang erhitzte Trägerkörper eingeleitet, wobei sich an den Trägerkörpern Silicium in fester Form abscheidet. Als Silicium enthaltende Komponenten werden bevorzugt Silan (SiH4), Monochlorsilan (SiH3Cl), Dichlorsilan (SiH2Cl2), Trichlorsilan (SiHCl3), Tetrachlorsilan (SiCl4) oder Mischungen der genannten Stoffe eingesetzt.

Das Siemens-Verfahren wird üblicherweise in einem Abscheidereaktor (auch "Siemens-Reaktor" genannt) durchgeführt. In der gebräuchlichsten Ausführungsform umfasst der Reaktor eine metallische Grundplatte und eine kühlbare Glocke, die auf die Grundplatte gesetzt ist, so dass ein Reaktionsraum im Inneren der Glocke entsteht. Die Grundplatte ist mit einer oder mehreren Gaseinlassöffnungen und einer oder mehreren Abgasöffnungen für die abgehenden Reaktionsgase sowie mit Halterungen versehen, mit deren Hilfe die Trägerkörper im Reaktionsraum gehalten und mit elektrischen Strom versorgt werden.

Jeder Trägerkörper besteht meistens aus zwei dünnen Filamentstäben und einer Brücke, die in der Regel benachbarte Stäbe an ihren freien Enden verbindet. Am häufigsten werden die Filamentstäbe aus ein- oder polykristallinem Silicium gefertigt, seltener kommen Metalle bzw. Legierungen oder Kohlenstoff zum Einsatz. Die Filamentstäbe stecken senkrecht in am Reaktorboden befindlichen Elektroden, über die der Anschluss an die Stromversorgung erfolgt. An den erhitzten Filamentstäben und der waagrechten Brücke scheidet sich hochreines Polysilicium ab, wodurch deren Durchmesser mit der Zeit anwächst. Nachdem der gewünschte Durchmesser erreicht ist, wird der Prozess beendet.

Moderne Reaktoren können bis zu 100 Filamentstäbe oder mehr enthalten. Eine hohe Stabanzahl ermöglicht eine hohe Reaktorproduktivität und reduziert den spezifischen Energieverbrauch, da die Energieverluste, z.B. durch die Strahlung zur kalten Reaktorwand, reduziert werden.

In Reaktoren gemäß Stand der Technik werden die Stäbe im Reaktor häufig auf konzentrischen Kreisen um den Mittelpunkt der Bodenplatte angeordnet. Die Anzahl der Kreise hängt dabei davon ab, wie viel Stäbe der Reaktor umfasst.

US 4681652 A offenbart Reaktoren mit 5, 6, 10, 12 und 20 Stäben, wobei die Stäbe jeweils auf zwei konzentrischen Kreisen nach den folgenden Schemata platziert sind: 1 + 4, 2 + 4, 4 + 6, 4 + 8, 8 + 12 (die erste Zahl gibt die Anzahl der Stäbe auf dem inneren Kreis, die zweite Zahl die Anzahl der Stäbe auf dem äußeren Kreis an).

US 2010/0043972 A1 offenbart einen Reaktor mit 48 Stäben, wobei die Stäbe auf drei Kreisen verteilt sind: 8 + 16 + 24. Dabei verbinden die Brücken die Stäbe innerhalb der Stabkreise paarweise so, dass die gebildeten Stabpaare bzw. Trägerkörper ebenfalls drei konzentrische Kreise bilden.

Da die Brückenlänge im Vergleich zur Stablänge klein ist, spielt die Lage der Brücken im Allgemeinen keine wesentliche Rolle.

Meistens werden zwei benachbarte Stäbe aus einem Kreis mittels einer Brücke verbunden (wie in oben erwähnten US 2010/0043972 A1).

Bekannt sind auch Ausführungen, wo Brücken teilweise radial ausgerichtet sind und zwei Stäbe aus den verschiedenen Kreisen miteinander verbunden sind.

CN 102 134 745 A offenbart eine Vorrichtung zur Abscheidung von polykristallinem Silizium mit einer hexagonalen Anordnung der Filamentstäbe.

In US 3011877 A ist ein Reaktor beschrieben, in dem die Stäbe geneigt sind und sich an ihren freien Enden berühren, so dass gar keine Brücke notwendig ist. Dort ist auch eine Möglichkeit der Verbindung von drei Stäben geschildert, wobei in diesem Fall die Energieversorgung mit einem dreiphasigen Drehstrom erfolgt.

Mit der steigenden Anzahl der Stäbe erhöht sich in der Regel auch die Anzahl der Kreise, auf denen die Stäbe angeordnet sind.

Aus US 2009/0136408 A1 ist ein Reaktor mit 98 Stäben bekannt, wobei die Stäbe auf 5 Kreisen verteilt sind (6 + 12 + 22 + 26 + 32).

Gaseinlassöffnungen (für das Eindüsen des frischen Reaktionsgas) werden meistens in der Reaktormitte (also innerhalb des inneren Stabkreises) und/oder zwischen den Stabkreisen platziert.

Abgasöffnungen sind in der Regel ebenfalls in der Reaktormitte (also innerhalb des inneren Stabkreises) und/oder zwischen dem äußeren Stabkreis und der Reaktorwand vorgesehen.

Bekannt sind auch Ausführungen, in denen das Abgas den Reaktor über Öffnungen im oberen Reaktorteil verlässt.

Manchmal werden Kühlelemente in den Reaktorraum eingebracht. Sie dienen zur Reduzierung der Gasraumtemperatur und können unterschiedlich gestaltet und positioniert werden.

In der Regel werden solche Kühlelemente als gekühlte Schutzschilder um Stäbe und/oder Brücken so ausgeführt, dass die Stäbe dadurch eingekapselt werden (s. z.B. EP 0 536 394 A1).

Bekannt sind auch Ausführungsformen mit einem von oben in den Reaktor eingesteckten Kühlfinger (DE 195 02 865 A1) oder mit einem gekühlten, mittig eingebrachten Rohr (DE 10 2009 003 368 B3), welches als Verlängerung einer Abgasöffnung ausgeführt ist.

In manchen Fällen befindet sich im Reaktorraum ein stationäres Heizelement, welches nur zum Zünden der Filamentstäbe eingeschaltet wird. Ein solches Heizelement befindet sich bei Reaktoren mit mehreren Stabkreisen meistens in der Reaktormitte, ist also innerhalb des inneren Stabkreises platziert (s. z.B. US 2009/0136408 A1 oder GB 1131462 A).

Bei der Herstellung dicker polykristalliner Siliciumstäbe (mit Durchmesser >100 mm) in den Siemens-Reaktoren nach dem Stand der Technik ist relativ häufig zu beobachten, dass die Stäbe Bereiche mit sehr rauer Oberfläche ("Popcorn") aufweisen. Diese rauen Bereiche müssen von dem restlichen Material abgetrennt und zu wesentlich niedrigeren Preisen als der restliche Siliciumstab verkauft werden.

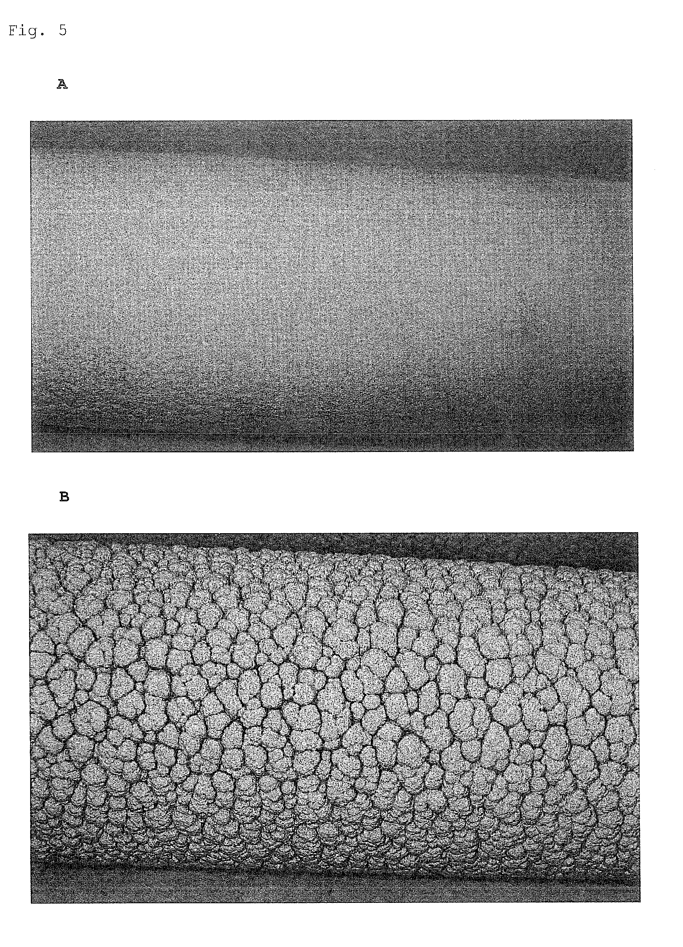

In **Fig. 5** sind Bereiche von Siliciumstäben mit glatter Oberfläche **(****Fig. 5 A)** und mit Popcorn-Oberfläche **(****Fig. 5 B)** gezeigt.

Durch eine Anpassung der Prozessparameter (z.B. Reduzierung Temperatur der Stäbe) kann der Anteil des Popcorn-Materials verringert werden (s. US 5904981 A1).

Solche Änderungen führen allerdings dazu, dass der Prozess langsamer läuft und damit die Ausbringung reduziert wird, was die Wirtschaftlichkeit verschlechtert.

Daher stellte sich die Aufgabe, polykristalline Stäbe aus hochreinem Silicium mit einem niedrigen Anteil an rauen Oberflächen wirtschaftlicher herzustellen.

Diese Aufgabe wird durch die vorliegende Erfindung gemäss einer Vorrichtung nach Anspruch 1 und eines Verfahrens nach Anspruch 10 gelöst.

Die Erfindung basiert darauf, Filamentstäbe und Gaseinlassöffnungen im Reaktor anders als im Stand der Technik zu platzieren.

Es hat sich gezeigt, dass so der Anteil an rauen Oberflächen ("Popcorn") bei sonst gleichen Prozessbedingungen überraschenderweise deutlich reduziert wird.

Dadurch lassen sich im Vergleich zum Stand der Technik bei gleicher Stabqualität deutlich schnellere Abscheideprozesse fahren, die die Wirtschaftlichkeit verbessern.

Die Aufgabe der Erfindung wird gelöst durch eine Vorrichtung zur Abscheidung von polykristallinem Silicium, umfassend eine Reaktorkammer mit einer Reaktorwand, wenigstens 20 Filamentstäbe sowie Gaseinlassöffnungen für Reaktionsgas in der Reaktorkammer, wobei sich bei jedem Filamentstab - mit Ausnahme der Filamentstäbe nahe der Reaktorwand - in einem Abstand von 150 bis 450 mm drei weitere benachbarte Filamentstäbe und eine bis drei benachbarte Gaseinlassöffnungen befinden, wobei die Reaktorkammer einen sechseckigen Querschnitt aufweist.

Vorzugsweise befinden sich bei jedem Filamentstab - mit Ausnahme der Filamentstäbe nahe der Reaktorwand - in einem Abstand von 250 bis 350 mm drei weitere Filamentstäbe und eine bis drei Gaseinlassöffnungen.

Vorzugsweise beträgt eine Differenz in den Entfernungen eines Filamentstabs zu den einzelnen benachbarten Filamentstäben und Gaseinlassöffnungen weniger als 50%, besonders bevorzugt weniger als 25% und ganz besonders bevorzugt weniger als 10%, beträgt.

Vorzugsweise beträgt ein Winkel zwischen den Richtungen eines Filamentstabs zu seinen benachbarten Filamentstäben und zu seinen benachbarten Gaseinlassöffnungen 90-150°, bevorzugt 105-135° und ganz besonders bevorzugt 115-125° beträgt.

Vorzugsweise beträgt eine Länge der Filamentstäbe ein 5- bis 15-faches, bevorzugt ein 8- bis 12-faches eines Abstands zwischen benachbarten Stäben.

Vorzugsweise handelt es sich bei den Gaseinlassöffnungen um Düsen, die bezüglich einer Bodenplatte der Reaktorkammer senkrecht nach oben ausgerichtet sind.

Vorzugsweise weisen die Gaseinlassöffnungen jeweils eine Querschnittsfläche von 1 und 10.000 mm² auf.

Vorzugsweise weist die Reaktorkammer einen runden oder einen an die Zahl der Filamentsstäbe und eine optimale Raumnutzung angepassten, beispielsweise sechseckigen Querschnitt auf.

Vorzugsweise ist die erfindungsgemäße Vorrichtung weiterhin **dadurch gekennzeichnet, dass** wenigstens eine bezüglich eines Querschnitts der Reaktorkammer zentrale Gaseinlassöffnung vorgesehen ist, wobei eine oder mehrere Abgasöffnungen neben jener wenigstens einen zentralen Gaseinlassöffnung herum und/oder zwischen Reaktorwand und den nahe der Reaktorwand befindlichen Filamentstäben platziert sind.

Vorzugsweise zeichnet sich die erfindungsgemäße Vorrichtung darüber hinaus dadurch aus, dass einer oder mehrere Kühlkörper und/oder ein oder mehrere Heizelemente in der Reaktorkammer vorhanden sind, wobei diese über Gaseinlassöffnungen angeordnet werden oder statt Gaseinlassöffnungen in der Reaktorkammer platziert sind.

Die Aufgabe der Erfindung wird auch gelöst durch ein Verfahren zur Abscheidung von polykristallinem Silicium auf Filamentstäben in einer zuvor genannten Vorrichtung, wobei mittels der Gaseinlassöffnungen ein Silicium enthaltendes Gas in die Reaktorkammer eingebracht wird und die Filamentstäbe auf eine Temperatur aufgeheizt werden, bei der sich Silicium auf diesen abscheidet.

Bei den Filamentstäben handelt es sich vorzugsweise um dünne Siliciumstäbe, oftmals auch Dünnstäbe genannt, und im Folgenden der Einfachheit halber als Siliciumstäbe bezeichnet.

Der erfindungsgemäße Reaktor umfasst wenigstens 20 solcher Siliciumstäbe, auf denen während des Siemensprozesses polykristallines Silicium abgeschieden wird sowie Gaseinlassöffnungen, beispielsweise Zugasdüsen, um Silicium enthaltendes Reaktionsgas in den Reaktor einzubringen.

Wesentlich für das Gelingen der Erfindung ist es, dass Filamentstäbe und Zugasdüsen wie folgt angeordnet sind:

Jeder Siliciumstab (davon ausgenommen Stäbe, die neben der Reaktorwand stehen) muss in einem Abstand von 150 bis 450 mm drei weitere Siliciumstäbe und eine bis drei Zugasdüsen besitzen. Jene drei weiteren Siliciumstäbe werden als benachbarte Stäbe oder Nachbarstäbe bezeichnet.

Vorzugsweise liegt der Abstand zu Düsen und Nachbarstäben zwischen 200 und 350 mm.

Die einzelnen Abstände zwischen den benachbarten Siliciumstäben bzw. Düsen können sich unterscheiden, liegen jedoch vorzugsweise zwischen 150 und 450 mm, besonders bevorzugt zwischen 200 und 350 mm.

Vorzugsweise beträgt eine Differenz in den Entfernungen zu den einzelnen benachbarten Siliciumstäben und Düsen weniger als 50%, besonders bevorzugt weniger als 25% und ganz besonders bevorzugt weniger als 10%.

Die Siliciumstäbe neben der Reaktorwand haben im gleichen Abstand nur 1 bis 3 drei weitere Siliciumstäbe und 1 bis 3 Gaseinlassöffnungen.

Die Winkel zwischen den Richtungen von Siliciumstab zu den Nachbarstäben und vom Siliciumstab zu den Nachbardüsen liegen vorzugsweise zwischen 90 und 150°, besonders bevorzugt zwischen 105 und 135°, ganz besonders bevorzugt um 115-125°.

Eine Länge der Siliciumstäbe beträgt vorzugsweise das 5- bis 15-fache, bevorzugt das 8- bis 12-fache des Abstands zwischen benachbarten Stäben.

Vorzugsweise sind die Düsen senkrecht nach oben ausgerichtet.

Vorzugsweise weisen die Düsen jeweils eine Querschnittsfläche von 1 bis 10.000 mm² auf.

Besonders bevorzugt haben die Düsen einen runden Querschnitt sowie einen Durchmesser zwischen 3 und 100 mm.

Neben den nach oben gerichteten Düsen sind zusätzliche nach unten oder seitlich ausgerichteten Düsen im oberen Reaktorteil ebenfalls bevorzugt.

Der Reaktor selbst kann einen runden oder einen an den Umfang der Siliciumstäbe angepassten, zum Beispiel sechseckigen Querschnitt haben.

Eine oder mehrere Abgasöffnungen werden bevorzugt in der Reaktormitte um die zentralen Düsen herum oder neben den zentralen Düsen platziert und/oder zwischen Reaktorwand und den äußeren Siliciumstäben platziert.

Werden ein oder mehrere Kühlkörper in den Reaktor eingebracht, können sie über oder statt einer oder mehrerer Düsen platziert werden.

Werden ein oder mehrere Heizelemente in den Reaktor eingebracht, können sie über oder statt einer oder mehrerer Düsen platziert werden.

Werden polykristalline Siliciumstäbe in solchen erfindungsgemäßen Abscheidereaktoren hergestellt, haben diese signifikant weniger Popcorn.

Bei gleichbleibender Stabqualität lassen sich (z.B. aufgrund höherer Temperatur der Si-Stäbe) deutlich schnellere und dadurch wirtschaftlichere Abscheideprozesse fahren.

Die Erfindung wird im Folgenden anhand von **Fig. 1-4** erläutert.

### Kurzbeschreibung der Figuren

**Fig. 1** zeigt schematisch einen Querschnitt eines Reaktors mit Stäben und Gaseinlassöffnungen.
**Fig. 2** zeigt schematisch einen Querschnitt eines Reaktors mit Stäben und Gaseinlassöffnungen.
**Fig. 3** zeigt schematisch einen Querschnitt eines Reaktors mit Stäben und Gaseinlassöffnungen.
**Fig. 4** zeigt schematisch einen Querschnitt eines Reaktors mit Stäben und Gaseinlassöffnungen.
**Fig. 5** zeigt Bereiche von Siliciumstäben mit glatter Oberfläche, **Fig. 5** **A** und mit Popcorn-Oberfläche, **Fig. 5** **B.**

### Liste der verwendeten Bezugszeichen

**1** Filament- bzw. Siliciumstäbe
**2** Gaseinlassöffnungen
**3** Reaktorwände

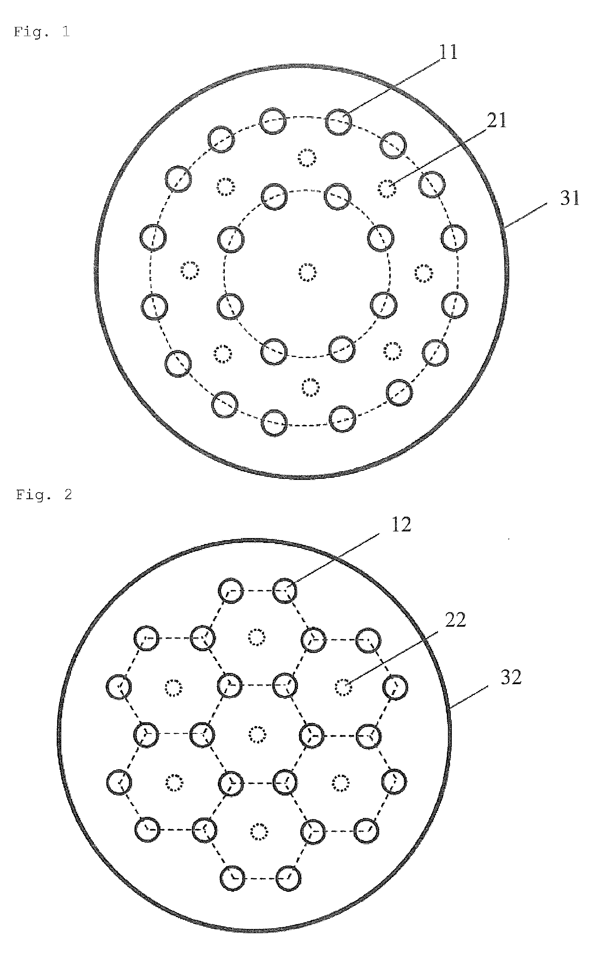

**Fig. 1** zeigt schematisch den Aufbau eines herkömmlichen Siemens-Reaktors mit 24 Siliciumstäben **11,** Gaseinlassöffnungen **21** und Reaktorwand **31.**

Mit gestrichenen Linien sind Kreise gezeigt, auf denen die Siliciumstäbe angeordnet sind.

**Fig. 2** zeigt schematisch einen erfindungsgemäßen Reaktor mit 24 Siliciumstäben **12,** Gaseinlassöffnungen **22** und Reaktorwand **32.**

Gestrichene Linien verbinden jeden Siliciumstab **12** mit drei benachbarten Stäben **12.**

Ausnahmen bilden hier die neben der Reaktorwand 32 stehenden Siliciumstäbe **12,** die nur zwei weitere Stäbe **12** in ihrer nächsten Umgebung haben.

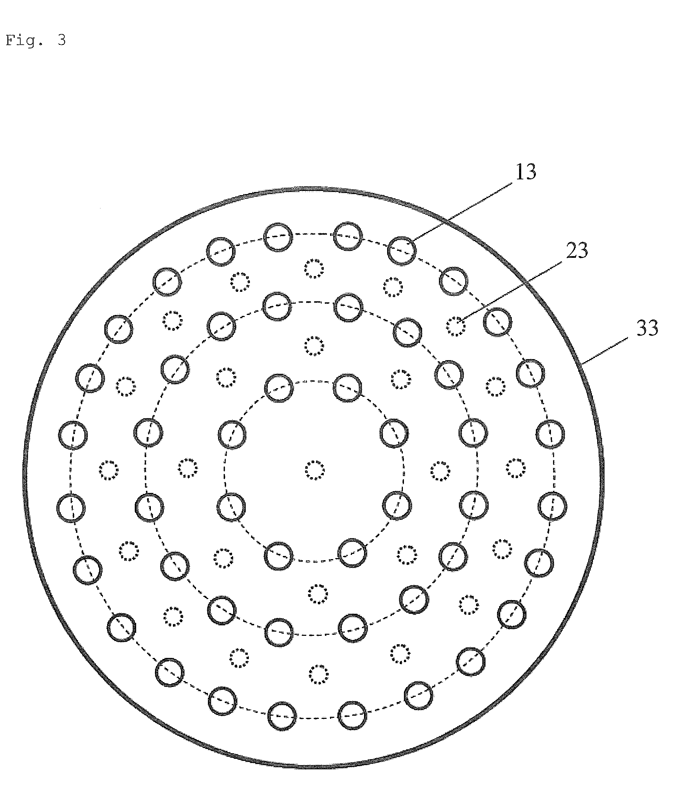

**Fig. 3** zeigt einen Siemens-Reaktor mit 48 Siliciumstäben **13** Gaseinlassöffnungen **23** und Reaktorwand **33** nach dem Stand der Technik. Mit gestrichenen Linien sind Kreise gezeigt, auf denen die Siliciumstäbe **13** verteilt sind.

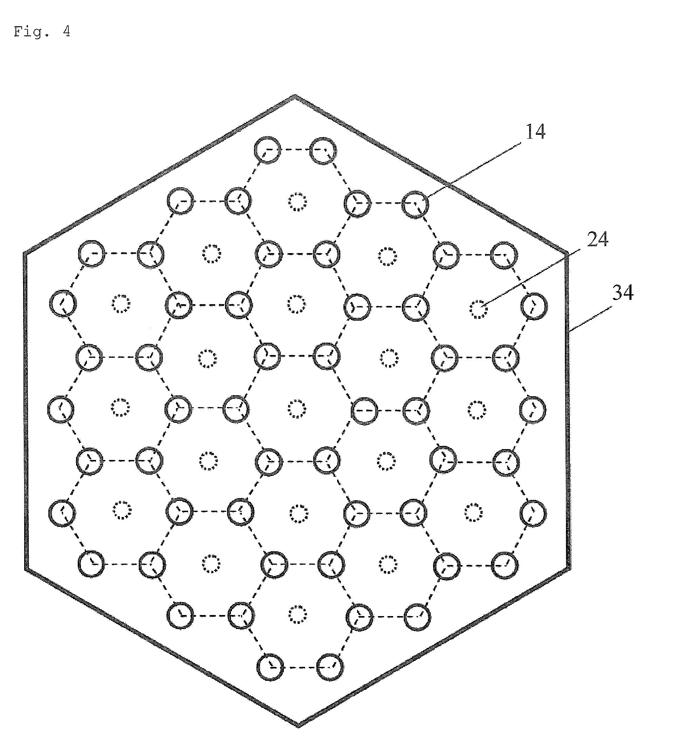

**Fig. 4** zeigt schematisch einen erfindungsgemäßen Reaktor mit 54 Siliciumstäben **14,** Gaseinlassöffnungen **24** und Reaktorwand **34.** Gestrichene Linien verbinden jeden Siliciumstab **14** mit drei benachbarten Stäben **14.** Ausnahmen bilden hier die neben der Reaktorwand 34 stehenden Siliciumstäbe **14,** die nur zwei weitere Stäbe **14** in ihrer nächsten Umgebung haben.

Hier ist ein Reaktor mit einem sechseckigen Querschnitt dargestellt. Ein runder Querschnitt wie in **Fig. 2** ist ebenfalls möglich und bevorzugt.

### Beispiele und Vergleichsbeispiele

In Siemensreaktoren mit unterschiedlicher Anordnung der Stäbe wurde der gleiche Abscheideprozess gefahren:

Das Reaktionsgas bestand jeweils aus Trichlorsilan (TCS) und Wasserstoff, wobei der TCS-Anteil konstant bei 20 Mol-% lag.

Die Gaszufuhr während der Abscheidung wurde jeweils so geregelt, dass der TCS-Durchfluss 0,5 kmol pro 1 m² Staboberfläche und pro 1 Stunde betrug.

Die Temperatur der Stäbe wurde jeweils so geregelt, dass der Durchmesser der Stäbe mit einer gleichmäßigen Geschwindigkeit von 1 mm pro h wuchs.

Nach dem Ausbau wurde der Anteil der rauen Oberfläche (Popcorn) bei den Stäben vermessen. Dabei wurden Si-Stäbe mit einer transparenten Folie umwickelt und die Bereiche mit Popcorn-Oberfläche (wie in Fig. 5 rechts) markiert. Anschließend wurde die markierte Folienfläche gemessen und bezogen auf die Gesamtfläche des Stabes in den Anteil der Popcorn-Oberfläche umgerechnet. Da der Übergang zwischen der glatten und der Popcorn-Oberfläche nicht immer sehr scharf ist, sind die erhaltenen Zahlen nicht sehr präzis. Sie geben aber einen zuverlässigen qualitativen Vergleich zwischen den getesteten Reaktortypen an.

### Vergleichsbeispiel 1

In diesem Beispiel wurde der oben beschriebene Prozess in einem herkömmlichen Siemensreaktor (Innendurchmesser 1500 mm) mit 24 Stäben (je 2,5 m lang) gefahren.

Diese standen in 2 Kreisen: 8 Stäbe im 1. Kreis mit 500 mm Durchmesser und 16 Stäbe im 2. Kreis mit 1000 mm Durchmesser (vgl. **Fig. 1**).

Innerhalb der Kreise waren die Stäbe gleichmäßig verteilt.

Die Zugasdüsen befanden sich in der Reaktormitte (1 Stück) und zwischen den Stabkreisen (8 Stück).

Die Abscheidung erfolgte bis zu einem Stabdurchmesser von 150 mm.

Im Mittel lag der Anteil der rauen Oberfläche in diesem Fall bei 15%.

### Beispiel 1

In dem zweiten Beispiel wurde der gleiche Abscheideprozess in einem erfindungsgemäßen Reaktor (vgl. **Fig. 2**) gefahren.

Der Reaktor (Innendurchmesser 1500 mm) hatte 24 Stäbe (je 2,5 m) und 7 Düsen.

Die Abstände zwischen den benachbarten Stäben und die Entfernungen vom Stab bis zu den nächsten Düsen waren alle gleich und betrugen 220 mm.

So ergab sich der gleiche Winkel von 120° zwischen den Richtungen vom Stab zu den Nachbarstäben und vom Stab zu den Nachbardüsen.

In diesem Fall machte die raue Oberfläche (Popcorn) bei den auf 150 mm abgeschiedenen Stäben einen Anteil von nur etwa 5% aus.

### Vergleichsbeispiel 1

In diesem Beispiel wurde der oben beschriebene Prozess in einem herkömmlichen Siemensreaktor (Innendurchmesser 2000 mm) mit 48 Stäben (je 2,5 m lang) gefahren.

Diese bildeten 3 Kreise: 8 Stäbe im 1. Kreis mit 500 mm Durchmesser, 16 Stäbe im 2. Kreis 1000 mm Durchmesser und 24 Stäbe im 3. Kreis mit 1500 mm Durchmesser (vgl. **Fig. 3**).

Innerhalb dieser Kreise waren die Stäbe gleichmäßig verteilt. Die Zugasdüsen befinden sich in der Reaktormitte (1 Stück), zwischen dem inneren und dem mittleren Stabkreisen (8 Stück) sowie zwischen dem mittleren und dem äußeren Stabkreisen (16 Stück).

Die Abscheidung erfolgte ebenfalls bis zu einem Stabdurchmesser von 150 mm.

Der Popcorn-Anteil bei den abgeschiedenen Stäben betrug in diesem Fall im Mittel 20%.

### Beispiel 2

In diesem Beispiel wurde ein erfindungsgemäße Reaktor mit 54 Stäben (je 2,5 m), einem sechseckigen Querschnitt (Seitenlänge innen 1000 mm) und 19 Gaseinlassöffnungen (Düsen) verwendet (vgl. **Fig. 4**).

Die Abstände zwischen den benachbarten Stäben und die Entfernungen vom Stab bis zu den nächsten Düsen waren alle gleich und betrugen 220 mm.

So ergab sich der gleiche Winkel von 120° zwischen den Richtungen vom Stab zu den Nachbarstäben und vom Stab zu den Nachbardüsen.

In diesem Fall betrug der Popcorn-Anteil bei den auf 150 mm abgeschiedenen Stäben im Mittel nur etwa 5%.

## Patentansprüche

1. Vorrichtung zur Abscheidung von polykristallinem Silicium, umfassend eine Reaktorkammer mit einer Reaktorwand, wenigstens 20 Filamentstäbe sowie Gaseinlassöffnungen für Reaktionsgas in der Reaktorkammer, wobei sich bei jedem Filamentstab - mit Ausnahme der Filamentstäbe neben der Reaktorwand - in einem Abstand von 150 bis 450 mm drei weitere benachbarte Filamentstäbe und eine bis drei benachbarte Gaseinlassöffnungen befinden, wobei die Reaktorkammer einen sechseckigen Querschnitt aufweist.

2. Vorrichtung nach Anspruch 1, wobei sich bei jedem Filamentstab - mit Ausnahme der Filamentstäbe neben der Reaktorwand - in einem Abstand von 250 bis 350 mm drei weitere benachbarte Filamentstäbe und eine bis drei benachbarte Gaseinlassöffnungen befinden.

3. Vorrichtung nach einem der Ansprüche 1 oder 2, wobei eine Differenz in den Entfernungen eines Filamentstabs zu den drei weiteren benachbarten Filamentstäben und den benachbarten Gaseinlassöffnungen weniger als 50% beträgt.

4. Vorrichtung nach einem der Ansprüche 1 bis 3, wobei ein Winkel zwischen den Richtungen eines Filamentstabs zu seinen drei weiteren benachbarten Filamentstäben und zu seinen zwei bis drei benachbarten Gaseinlassöffnungen 90-150° beträgt.

5. Vorrichtung nach einem der Ansprüche 1 bis 4, wobei eine Länge der Filamentstäbe ein 5- bis 15-faches eines Abstands zwischen benachbarten Stäben beträgt.

6. Vorrichtung nach einem der Ansprüche 1 bis 5, wobei es sich bei den Gaseinlassöffnungen um Düsen handelt, die bezüglich einer Bodenplatte der Reaktorkammer senkrecht nach oben ausgerichtet sind.

7. Vorrichtung nach einem der Ansprüche 1 bis 6, wobei die Gaseinlassöffnungen eine Querschnittsfläche von 1 bis 10.000 mm² aufweisen.

8. Vorrichtung nach einem der Ansprüche 1 bis 7, wobei wenigstens eine bezüglich eines Querschnitts der Reaktorkammer zentrale Gaseinlassöffnung vorgesehen ist, wobei eine oder mehrere Abgasöffnungen neben jener wenigstens einen zentralen Gaseinlassöffnung herum und/oder zwischen Reaktorwand und den nahe der Reaktorwand befindlichen Filamentstäben platziert sind.

9. Vorrichtung nach einem der Ansprüche 1 bis 8, wobei einer oder mehrere Kühlkörper und/oder ein oder mehrere Heizelemente in der Reaktorkammer vorhanden sind, wobei diese über Gaseinlassöffnungen angeordnet sind oder statt Gaseinlassöffnungen in der Reaktorkammer platziert sind.

10. Verfahren zur Abscheidung von polykristallinem Silicium auf Filamentstäben in einer Vorrichtung nach einem der Ansprüche 1 bis 9, wobei mittels der Gaseinlassöffnungen ein Silicium enthaltendes Gas in die Reaktorkammer eingebracht wird und die Filamentstäbe auf eine Temperatur aufgeheizt werden, bei der sich Silicium auf diesen abscheidet.

## Claims

1. Apparatus for deposition of polycrystalline silicon, comprising a reactor chamber with a reactor wall, at least 20 filament rods and gas inlet orifices for reaction gas in the reactor chamber, wherein each filament rod - except for the filament rods next to the reactor wall - has, at a distance of 150 to 450 mm, three further adjacent filament rods and one to three adjacent gas inlet orifices, wherein the reactor chamber has a hexagonal cross section.

2. Apparatus according to Claim 1, wherein each filament rod - except for the filament rods next to the reactor wall - has, at a distance of 250 to 350 mm, three further adjacent filament rods and one to three adjacent gas inlet orifices.

3. Apparatus according to either of Claims 1 to 2, wherein a difference in the distances of any filament rod from the three further adjacent filament rods and the adjacent gas inlet orifices is less than 50%.

4. Apparatus according to any of Claims 1 to 3, wherein an angle between the directions from any filament rod to its three further adjacent filament rods and to its two to three adjacent gas inlet orifices is 90-150°.

5. Apparatus according to any of Claims 1 to 4, wherein a length of the filament rods is 5 to 15 times a distance between adjacent rods.

6. Apparatus according to any of Claims 1 to 5, wherein the gas inlet orifices are nozzles which are directed vertically upward with respect to a base plate of the reactor chamber.

7. Apparatus according to any of Claims 1 to 6, wherein the gas inlet orifices have a cross-sectional area of 1 to 10 000 mm².

8. Apparatus according to any of Claims 1 to 7, wherein at least one gas inlet orifice central with respect to a cross section of the reactor chamber is provided, with one or more offgas orifices positioned next to and around that at least one central gas inlet orifice and/or between reactor wall and the filament rods close to the reactor wall.

9. Apparatus according to any of Claims 1 to 8, wherein one or more cooling bodies and/or one or more heating elements are present in the reactor chamber, these being arranged above gas inlet orifices or being positioned in the reactor chamber in place of gas inlet orifices.

10. Process for depositing polycrystalline silicon on filament rods in an apparatus according to any of Claims 1 to 9, wherein the gas inlet orifices are used to introduce a silicon-containing gas into the reactor chamber and the filament rods are heated to a temperature at which silicon is deposited thereon.

## Revendications

1. Dispositif de dépôt de silicium polycristallin, comprenant une chambre de réacteur munie d'une paroi de réacteur, au moins 20 barreaux filamentaires, ainsi que des ouvertures d'entrée de gaz pour un gaz de réaction dans la chambre de réacteur, dans lequel, pour chaque barreau filamentaire, à l'exception des barreaux filamentaires adjacents à la paroi du réacteur, trois autres barreaux filamentaires voisins et une à trois ouvertures d'entrée de gaz voisines se trouvent à une distance de 150 à 450 mm, la chambre de réacteur présentant une section hexagonale.

2. Dispositif selon la revendication 1, dans lequel, pour chaque barreau filamentaire, à l'exception des barreaux filamentaires adjacents à la paroi du réacteur, trois autres barreaux filamentaires voisins et une à trois ouvertures d'entrée de gaz voisines se trouvent à une distance de 250 à 350 mm.

3. Dispositif selon l'une quelconque des revendications 1 ou 2, dans lequel une différence entre les écarts entre un barreau filamentaire et les trois autres barreaux filamentaires voisins et les ouvertures d'entrée de gaz voisines est inférieure à 50 %.

4. Dispositif selon l'une quelconque des revendications 1 à 3, dans lequel un angle entre les directions d'un barreau filamentaire et de ses trois autres barreaux filamentaires voisins et de ses deux à trois ouvertures d'entrée de gaz voisines est de 90 à 150°.

5. Dispositif selon l'une quelconque des revendications 1 à 4, dans lequel une longueur des barreaux filamentaires est de 5 à 15 fois un écart entre des barreaux voisins.

6. Dispositif selon l'une quelconque des revendications 1 à 5, dans lequel les ouvertures d'entrée de gaz sont des buses, qui sont orientées perpendiculairement vers le haut par rapport à une plaque de fond de la chambre de réacteur.

7. Dispositif selon l'une quelconque des revendications 1 à 6, dans lequel les ouvertures d'entrée de gaz présentent une surface de section transversale de 1 à 10 000 mm².

8. Dispositif selon l'une quelconque des revendications 1 à 7, dans lequel au moins une ouverture d'entrée de gaz centrale par rapport à une section transversale de la chambre de réacteur est prévue, une ou plusieurs ouvertures de gaz d'échappement étant placées autour de chaque ouverture d'entrée de gaz centrale et/ou entre la paroi du réacteur et les barreaux filamentaires se trouvant à proximité de la paroi du réacteur.

9. Dispositif selon l'une quelconque des revendications 1 à 8, dans lequel un ou plusieurs corps réfrigérants et/ou un ou plusieurs éléments chauffants sont présents dans la chambre de réacteur, ceux-ci étant agencés par le biais d'ouvertures d'entrée de gaz ou placés à la place d'ouvertures d'entrée de gaz dans la chambre de réacteur.

10. Procédé de dépôt de silicium polycristallin sur des barreaux filamentaires dans un dispositif selon l'une quelconque des revendications 1 à 9, dans lequel un gaz contenant du silicium est introduit dans la chambre de réacteur au moyen des ouvertures d'entrée de gaz et les barreaux filamentaires sont portés à une température à laquelle le silicium se dépose sur ceux-Ci.
